# EUROPEAN PATENT APPLICATION

(11) **EP 4 276 920 A1**
(43) Date of publication of application: **15.11.2023**
(21) Application number: 23172486.5
(22) Date of filing: 10.05.2023
(51) Int. Cl.: H01L 31/18

(54) **METHOD FOR MANUFACTURING A SEMI-FINISHED CDTE BASED THIN FILM SOLAR CELL DEVICE**

(30) Priority: 10.05.2022 CN 202210508012
(71) Applicant: China Triumph International Engineering Co., Ltd., Shanghai 200063 (CN); CTF Solar GmbH, 01099 Dresden (DE)
(72) Inventor: Peng, Shou, Shanghai (CN); Ma, Liyun, Shanghai (CN); Yin, Xinjian, Shanghai (CN); Fu, Ganhua, Shanghai (CN); Menossi, Daniele, Dresden (DE)
(74) Representative: Kailuweit & Uhlemann Patentanwälte Partnerschaft mbB

(57) **Abstract**

The invention concerns a method for manufacturing a semi-finished CdTe based thin film solar cell device at least comprising the steps of providing a substrate, forming a CdTe based absorber layer on the substrate, performing an activation treatment and performing a light treatment. The light treatment is simultaneously performed with the activation treatment.

## Description

The invention concerns a method for manufacturing a semi-finished CdTe based thin film solar cell device, in particular with a special step supporting an activation treatment

### State of the art

In the state of the art, CdTe based thin film solar cell devices are produced in superstrate configuration with the following process sequence: on a usually transparent substrate, like a glass substrate a first electrode layer is deposited as a front contact. On this, a layer of cadmium sulfide (CdS) or another window layer may be deposited, followed by a CdTe based absorber layer. The CdTe based absorber layer is then activated with an activating agent, e.g. CDCL, and a temperature treatment step. Finally, a second electrode layer, e.g. metal layer or a metal compound layer is applied as a back contact to collect the charge carriers. Also CdTe based thin film solar cell devices in substrate configuration are known from state of the art, which are formed in reverse process sequence with respect of the deposition steps.

The CdTe based absorber layer may be deposited by a variety of different methods known from state of the art, like physical vapour deposition (PVD), electrochemical deposition and so on. Furthermore, the CdTe based absorber layer according to the invention may also comprise CdSeₓTe₁₋ₓ layers or other compounds comprising Cd and Te as well as dopants.

The activation treatment of the CdTe based absorber layer is a crucial step in manufacturing CdTe based thin film solar cell devices enabling for example intermixing of different absorber layer materials, doping of the absorber layer as well as reducing defect density within the absorber layer. New methods of production CdTe based thin film solar cell devices are constantly being investigated to improve photovoltaic efficiency.

For example, CN 103 173 829 A discloses a method for preparing CdTe semiconductor films by electrochemical deposition under irradiation with a light source, like a xenon lamp, mercury xenon lamp, metal halide lamp etc. to improve the preparation efficiency resulting in thicker CdTe films in the same deposition time and improved crystallinity of the CdTe semiconductor films.

Other developments try to improve the composition of the absorber layer by incorporating doping elements at predetermined places within the absorber layer or by changing the stoichiometry of the absorber layer over its thickness by forming Cd, Se or Te rich portions. For example, US 2011 0143493 A1, US 10,529,883 B2 and US 2011 0117696 A1 show different approaches. US 2011 0143493 A1 describes different methods for obtaining enhanced p-type doping levels within a photo-active CdTe material. US 10,529,883 B2 discloses forming a CdSeₓTe₁₋ₓ compound absorber layer with a defined amount and distribution of the Se over the thickness of the absorber layer. US 2011 0117696 A1 describes methods for forming a Te-rich surface of a CdTe absorber layer.

### Object of the invention

Object of the invention is therefore to provide an alternative method for manufacturing a semi-finished CdTe based thin film solar cell device with improved photovoltaic efficiency.

### Solution

The object is solved by a method according to the independent claim. Preferred embodiments are given in the dependent claims.

The method according to the present invention for manufacturing a semi-finished CdTe based thin film solar cell device comprises at least the following steps:
a) Providing a substrate,
b) Forming a CdTe based absorber layer on the substrate,
c) Performing an activation treatment, and
d) Performing a light treatment,
wherein the light treatment in step d) is simultaneously performed with the activation treatment in step c).

According to the invention, a substrate means any basis on which the CdTe based absorber layer is formed in step b). That is, the substrate may comprise a transparent base substrate, for instance of glass, a transparent front electrode and further layers like buffer layers, window layers or any else. In other embodiments, the substrate may comprise a transparent or opaque back electrode and further layers like buffer layers or any else. That is, the substrate may be glass, polymeric, metallic, or ceramic material or any other material.

A CdTe based absorber layer means an absorber layer like CdTe, CdSeₓTe₁₋ₓ , CdₓZn₁₋ₓTe, CdₓMn₁₋ₓTe, CdₓMg₁₋ₓTe, in each case undoped or doped with suitable doping materials. The CdTe based absorber layer may be formed using any technique known from the prior art, comprising, but not limited to, physical vapour deposition, e.g. sputtering, evaporation or sublimation, electrodeposition, or any else. The absorber layer may be deposited layer by layer, e.g. subsequently depositing one or a plurality of layers of CdSe and CdTe or of doping layers, followed by interdiffusion of the different layers if desired, or in one undivided process. Furthermore, processes for changing the composition of the surface portion of the absorber layer may be performed, for instance an NP etch (phosphorus nitride etch) for forming a Te-rich surface portion.

The activation treatment of the present invention induces recrystallization, reduces lattice defects and improves the pn junction or its formation. Furthermore, this step may improve intermixing of different compounds and/or elements resulting in forming of mixed or doped compounds. The activation treatment may comprise a thermal treatment and/or a treatment with a chemical activation agent. The activation treatment is known from the state of the art, wherein, however, parameters of the activation treatment according to the invention may differ from that of the prior art. Such parameters are, for instance, temperature, time or duration, the kind or the amount of the chemical activation agent or the composition and pressure of a surrounding atmosphere. Some of these differences will be explained later.

According to the invention, a light treatment of the absorber layer is simultaneously performed with the activation treatment. That means, that at any time during the activation treatment, electromagnetic radiation in form of light is provided to the absorber layer, wherein the light treatment may be performed for a time shorter or longer than or equal to the time of the activation treatment. In any case, the light treatment is performed after the absorber layer is formed, i.e. deposited.

Due to the light treatment, an additional internal electric field is formed within the absorber layer, wherein this additional internal electric field provides a drift potential to charged particles and therefore causes a controlled diffusion of these charged particles within the absorber layer. The additional internal electric field is additional since it is additional to an internal electric field caused by a pn-junction within the absorber layer. The diffusion of the charged particles is controlled by the strength and duration of the additional internal electric field.

For instance, chlorine has been found to diffuse inside CdTe and CdSeTe materials. While diffusing, Cl⁻ can fix in specific lattice positions to improve the photovoltaic properties of the absorber material. These positions can be substitutionals or complexes like, but not limited to, CI(Te), CI(Cd), or CITe-VCd and can cause a n- or p-doping of the absorber material, with a decrease or increase in charge carriers concentration. The diffusion length of the chlorine or of other charged particles is now controlled by the additional internal electric field, thereby defining the location of the changed lattice positions within the absorber layer over its thickness.

Furthermore, the additional internal electrical field supports the process of setting free charged particles from their original molecules. For instance, chlorine anions can be released from a chlorine-based chemical like CdCl₂, as well as H⁺ or O₂⁻ present in an activation treatment solution used, like for example, but not limited to, H₂0 or CH₃OH. Thus, the amount of active charged particles within the absorber material may be increased.

Although the invention concerns the treatment of the absorber layer with light in particular, it should be noted that any electromagnetic radiation causing an additional internal electric field within the absorber layer may be used for the treatment. Furthermore, the light treatment may be supported by an external electro-magnetic field provided, for instance, by plate capacitor, wherein the absorber layer is arranged between the plates of it, or by applying a voltage on at least one side of the absorber layer. In some cases, the light treatment may even be replaced by providing an external electro-magnetic field.

In embodiments, a method for manufacturing a semiconductor based thin film device comprises at least the following steps: a) providing a substrate, b) forming a semiconductor layer, c) performing an activation treatment, d) performing a light treatment, wherein the light treatment in step d) is simultaneously performed with the activation treatment in step c). Advantageously, this method improves semiconductor layer quality. In further embodiments, the semiconductor layer may be any semiconductor not sensitive to degradation by light irradiation.

In embodiments, the light treatment is performed with a light intensity in the range of 50 W/m² to 5000 W/m². In special embodiments, the light intensity is in the range of 1000 W/m² to 2000 W/m². High intensities of light, i.e. above 500 W/m², contribute to heating the absorber layer supporting the diffusion of particles. If using low intensities of light, i.e. less than 100 W/m², the diffusion of particles may be supported by heating the absorber layer using other techniques.

In embodiments, the light treatment is performed with wavelengths in the range of 300 nm to 900 nm, in particular between 400 nm and 700 nm. The light may comprise a full spectrum of wavelengths in the mentioned ranges, i.e. from UV to IR (infrared), or may comprise only some specific wavelengths or subranges in the mentioned ranges. If specific wavelengths or subranges are used, they may be used simultaneously or consecutively.

The light for the light treatment may be provided by any known light source, e.g. halogen lamps, LEDs, laser diodes, lasers, flash lamps and incandescent lights.

In embodiments, the light treatment is performed for a duration of 10 s to 30 min, in particular for a duration of 60 s to 20 min. The activation treatment may be performed for a duration of 30 s to 30 min, wherein the duration of the activation treatment may be shorter as compared to activation treatments using the same process conditions, like activation agent, temperature or surrounding atmosphere, of the prior art.

In embodiments, the light treatment is performed in open-circuit or short-circuit condition of the semi-finished CdTe based thin film solar cell device.

An open-circuit condition is implemented by just irradiating the absorber layer without electrically conductive connecting the absorber layer to a defined external electric termination or without electrically conductive connecting the both sides of the absorber layer with each other.

To perform light treatments in short-circuit condition, specific robotic manipulators could be implemented during the light treatment. These manipulators are equipped with electronic terminations and they can transport suitable current, and/or voltage signals. Suitable contacts can be placed in contact to electrodes already formed of the semi-finished solar cell or to the main layers, which constitute the p-n junction of the device. In order to establish an electrical short circuit within the semi-finished photovoltaic device, the electronic terminations are electrically conductive connected to each other.

Each of the mentioned conditions may be applied to the semi-finished solar cell along the whole treatment period, or also just for a certain portion of it, from 0% to 100% of the whole treatment period. It is even possible to implement both conditions consecutively in any order.

The light treatment is performed from a first interface of the CdTe based absorber layer oriented towards the substrate and/or from a second interface of the CdTe based absorber layer oriented away from the substrate. That is, the light may be irradiated onto the absorber layer from any side of the semi-finished solar cell with respect to its thickness direction. The thickness direction is that direction in which the substrate and the absorber layer lie above each other.

By choosing a specific side of the semi-finished solar cell in correspondence with the materials of the substrate and the absorber layer, the wavelengths emitted by the light source and its irradiation intensity, the incoming photons will be absorbed in different positions and depth inside the material irradiated. Thus, the strength of the additional internal electric field may be adjusted.

For example, if the light passes through the glass substrate and the initial material layers, it may be partially absorbed before arriving to the absorber region, useful to establish the electric field.

A first interface of the CdTe based absorber layer means the interface of the CdTe based absorber layer facing sunlight in a CdTe based thin film solar cell device in superstrate configuration or the interface of the CdTe based absorber layer not facing sunlight in a CdTe based thin film solar cell device in substrate configuration.

A second interface of the CdTe based absorber layer means the interface of the CdTe based absorber layer not facing sunlight in a CdTe based thin film solar cell device in superstrate configuration or the interface of the CdTe based absorber layer facing sunlight in a CdTe based thin film solar cell device in substrate configuration.

In embodiments, the activation treatment in step c) comprises applying an activation agent to the CdTe based absorber layer. This activation agent may, for instance, be CdClz or a composition comprising chlorine or chlorine ions or any other agent comprising halogen ions. The activation agent may be applied to the absorber layer as a solid, a liquid or a gaseous material using techniques known to a person skilled in the art.

Due to the method according to the invention, the used activation agent and its amount may be chosen more freely than in prior art. Furthermore, usually less activation agent is sufficient for achieving the same effects as compared with prior art.

In embodiments, the activation treatment in step c) comprises performing a thermal annealing treatment. That is, the absorber material is heated to a temperature in the range of 200°C to 450°C in order to provide sufficient activation energy to the absorber material and diffusing particles. For instance, chlorine has been found to diffuse inside CdTe and CdSeTe materials with activation energies in the range of 0.63 eV and 1.32 eV. Therefore, prior art activation treatment is performed at elevated temperatures, e.g. in the range of 350°C to 500°C. Due to the additional internal electric field supporting the diffusion of charged particles, the temperature of the thermal annealing treatment may be decreased with respect to prior art. The heating of the absorber material may be performed by any technique known from prior art, for instance by heater lamps heating the surrounding atmosphere of the absorber layer or electrical heating using resistors. Due to the light treatment, the absorber material may locally and/or temporarily be heated to temperatures higher than reached only by the above described heating, i.e. higher than 450°C, for instance 600°C.

Furthermore, in case the light used for light treatment comprises wavelengths in the infrared range and a sufficient intensity, additional heating of the absorber layer may be omitted. That is, the energy introduced by light treatment may be sufficient for diffusion of particles within the absorber layer and within the additional internal electric field.

In embodiments, the light treatment is performed under vacuum, under atmospheric conditions or under controlled gas pressure conditions, such as for example in an oxygen atmosphere, an argon atmosphere, in the presence of chlorine, hydrogen or nitrogen or combinations of the above. The controlled atmospheres may also be at reduced pressure with respect to atmospheric pressures, such as 100 mbar (10⁴ Pa) or below. The controlled gas pressure conditions may also include the presence of dopants, such as vapours of e.g. As, Sb or P.

Vacuum means a pressure in the range of 10⁻⁷ mbar (10⁻⁵ Pa) to 10⁻¹ mbar (10 Pa) in the surrounding of the semi-finished solar cell.

Atmospheric conditions means normal air under normal pressure.

In other examples, the surrounding of the semi-finished solar cell may comprise hydrogen and may have a partial pressure in the range of 1 mbar (100 Pa) to 100 mbar (10⁴ Pa). The benefit of hydrogen presence in the atmosphere is that the oxidation state of, for instance, dopant species in the activated absorber layer can be changed, just as well as other oxidizing or reducing atmospheres can be applied to the same effect of changing oxidation states of species within the absorber.

As described above, the method according to the invention may be used in manufacturing a CdTe based thin film solar cell device.

For realization of the invention it is advantageous to combine the described embodiments and features of the claims as described above. However, the embodiments of the invention described in the foregoing description are examples given by way of illustration and the invention is nowise limited thereto. Any modification, variation and equivalent arrangement should be considered as being included within the scope of the invention.

Although specific embodiments have been illustrated and described herein, it will be appreciated by those of ordinary skill in the art that a variety of alternate and/or equivalent implementations may be substituted for the specific embodiments shown and described without departing from the scope of the present invention. This application is intended to cover any adaptations or variations of the specific embodiments dis-cussed herein. Therefore, it is intended that this invention is limited only by the claims and the equivalents thereof.

### Exemplary embodiments

The accompanying drawings are included to provide a further understanding of embodiments of the invention and are incorporated in and constitute a part of this specification. The drawings illustrate the embodiments of the present invention and together with the description serve to explain the principles. Other embodiments of the invention and many of the intended advantages will be readily appreciated, as they be-come better understood by reference to the following detailed description. The elements of the drawings are not necessarily to scale relative to each other. Like reference numbers designate corresponding similar parts.
**Fig. 1** shows a schematic flow diagram of the method according to the invention.
**Fig. 2** shows an exemplary apparatus for performing the method according to the invention.

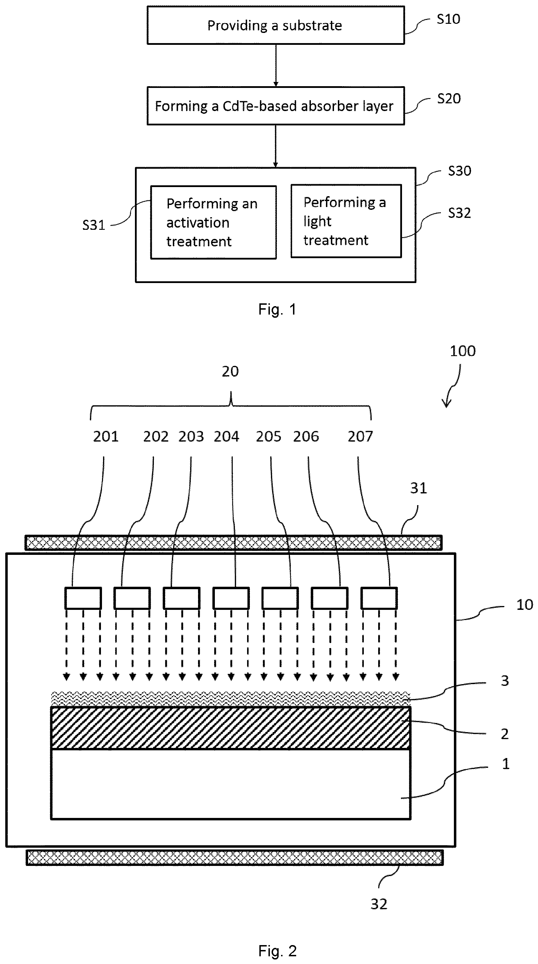

**Fig. 1** shows the process flow of the method according to the invention. In a first step S10, a substrate is provided onto which a CdTe-based absorber layer is formed in a next step S20. Subsequently, a step S30 is performed which comprises two substeps: a step of performing an activation treatment S31 and a step of performing a light treatment S32. Both substeps are performed at least partially simultaneously. That is, the light treatment S32 is performed while the activation treatment S31 is performed, wherein S32 may last shorter than step S31. The activation treatment S31 may comprise one or more substeps, like applying an activation agent onto a surface of the CdTe-based absorber layer, a temperature treatment step and a step of removing residues of the activation agent from the surface of the absorber layer. The light treatment S32 may be performed during applying the activation agent and/or during the temperature treatment step of the activation treatment 31.

**Fig. 2** shows an exemplary apparatus 100 for performing the method according to the invention. The apparatus 100 comprises a processing chamber 10 inside which a substrate 1 is arranged. A CdTe-based absorber layer 2 is formed on a surface of the substrate 1. An activation agent 3 is applied onto a surface of the CdTe-based absorber layer 2, wherein that surface does not join the substrate 1, but lies on the opposite side of the absorber layer 2. The activation agent 3 is not always necessary, but often used, for instance in form of CdCl₂. Inside the processing chamber 10, a light source 20 comprising, for instance, a plurality of halogen lamps 201 to 207 is arranged on that side of the CdTe-based absorber layer 2 on which the activation agent is applied. Each lamp 201 to 207 emits light (shown by the broken arrows) in the wavelength range of 510 nm to 540 nm and with an intensity in the range of 500 W/m² to 1000 W/m² for a time in the range of 60 s to 3 min. The light impinges onto the activation agent 3 and irradiates the CdTe-based absorber layer 2 thereby performing the light treatment according to the inventive method. The shown arrangement of the light source 20 on that side of the CdTe-based absorber layer 2 lying opposite the substrate 1 allows irradiating the absorber layer 2 even in the case the substrate 1 is not transparent for the light emitted by the light source 20.

In other embodiments, the light source 20 may be arranged on the other side of the substrate 1 such that light transmits through the substrate 1 before reaching the absorber layer 2. Furthermore, it is even possible to arrange light sources on both sides of the substrate 1 and the absorber layer 2, wherein the light sources may be different with respect to the wavelengths and the intensity of the emitted light.

Further, the light source 20 may comprise a plurality of lamps 201 to 207 as shown in Fig. 2, wherein the individual lamps 201 to 207 may differ with respect to the wavelengths and the intensity of the emitted light. Thus, the introduced energy may be adapted with respect to the lateral position within the absorber layer 2, wherein the lateral position is a position in a plane perpendicular to the thickness of the absorber layer 2. This allows to finely tune the diffusion of charged particles even with respect to the lateral position. The lamps 201 to 207 may be arranged

In other embodiments, the light source 20 may be formed by a single lamp or any known light source suitable to emit light in the suitable wavelengths range and with a suitable intensity.

The apparatus 100 further comprises two heaters 31 and 32, which are arranged on the outside of the processing chamber 10 on the top and the bottom of the processing chamber 10. The heaters 31 and 32 may be resistive heaters or heating lamps or fluid-based heating systems and are able to heat at least inside of the processing chamber 10 to a desired temperature in the range of 350°C to 500°C. The apparatus 100 may comprise further heaters not shown in Fig. 2 or the heaters 31, 32 may be arranged inside the processing chamber 10. There are different ways for achieving a desired temperature of the CdTe-based absorber layer 2 and - if applicable - the activation agent 3 known to a person skilled in the art.

Furthermore, it is not necessary for the apparatus 100 to comprise heaters. If the light irradiated by the light source 20 is sufficient to provide enough energy for performing the activation treatment, for instance by heating the absorber layer 2 due to infrared light, no additional heat has to be provided by heaters.

In the shown exemplary embodiment, the light treatment is performed in open-circuit condition. In other conditions, for instance in short-circuit condition, the apparatus 100 further comprises electrical connectors suitable for connecting opposite sides of the absorber layer 2 or for connecting an electrode being part of the substrate 1 and being in contact with one side of the absorber layer 2 and the other side of the absorber layer 2 with each other(short-circuit condition) or each with a different defined potential.

Further, the light treatment is performed under atmospheric air conditions in the shown exemplary apparatus 100. In other embodiments, the apparatus 100 may further comprise at least one gas inlet and at least one gas outlet connected to the processing chamber 10. The gas inlet is suitable for introducing a specific gas or gas compound into the inside of the processing chamber 10, and the gas outlet is suitable for discharging a gas from the inside of the processing chamber 10 and to adjust a pressure inside the processing chamber 10. The gas outlet may be connected to a vacuum pump. An example for a processing atmosphere inside the processing chamber 10 is, for instance, 100 mbar (10⁴ Pa) of hydrogen or as another example 1 bar (10⁵ Pa) of nitrogen.

The embodiments of the invention described in the foregoing description are examples given by way of illustration and the invention is nowise limited thereto. Any modification, variation and equivalent arrangement as well as combinations of embodiments should be considered as being included within the scope of the invention.

### Reference signs

- 1: Substrate
- 2: CdTe-based absorber layer
- 3: Activation agent
- 10: Processing chamber
- 20: Light source
- 201-207: Halogen lamp
- 31, 32: Heater
- 100: Apparatus for performing the inventive method

## Claims

1. Method for manufacturing a semi-finished CdTe based thin film solar cell device at least comprising the following steps:
a) Providing a substrate,
b) Forming a CdTe based absorber layer on the substrate,
c) Performing an activation treatment,
d) Performing a light treatment,
wherein the light treatment in step d) is simultaneously performed with the activation treatment in step c).

2. Method according to claim 1, **characterized in that** the light treatment is performed with a light intensity in the range of 50 W/m² to 5000 W/m².

3. Method according to claim 1 or 2, **characterized in that** the light treatment is performed with wavelengths in the range of 300 nm to 900 nm.

4. Method according to one of the claims 1 to 3, **characterized in that** the light treatment is performed for a duration of 10 s to 30 min.

5. Method according to one of the claims 1 to 4, **characterized in that** the light treatment is performed in open-circuit or short-circuit condition of the semi-finished CdTe based thin film solar cell device.

6. Method according to one of the claims 1 to 5, **characterized in that** the light treatment is performed from a first interface of the CdTe based absorber layer oriented towards the substrate and/or from a second interface of the CdTe based absorber layer oriented away from the substrate.

7. Method according to one of the claims 1 to 6, **characterized in that** the activation treatment in step c) comprises applying an activation agent to the CdTe based absorber layer.

8. Method according to one of the claims 1 to 7, **characterized in that** the activation treatment in step c) comprises performing a thermal annealing treatment with a temperature in the range of 200°C to 450°C.

9. Method according to one of the claims 1 to 8, **characterized in that** the light treatment is performed under vacuum, under atmospheric conditions or under controlled gas pressure or in a defined gas environment comprising any gas selected from oxygen, nitrogen, hydrogen, chlorine and argon or combinations thereof.
